# EUROPEAN PATENT APPLICATION

(11) **EP 1 744 599 A1**
(43) Date of publication of application: **17.01.2007**
(21) Application number: 05727637.0
(22) Date of filing: 01.04.2005
(51) Int. Cl.: H05B 33/24, H05B 33/12, H05B 33/26

(54) **ELECTRO-LUMINESCENCE ELEMENT**

(30) Priority: 08.04.2004 JP 2004114514
(71) Applicant: Matsushita Toshiba Picture Display Co., Ltd., Takatsuki-shi, Osaka 569-1193 (JP)
(72) Inventor: WATANABE, Hirotoshi, Osaka 567-0085 (JP); KAWASAKI, Masaki, Osaka 560-0014 (JP)
(74) Representative: Tothill, John Paul
(86) International application number: PCT/JP2005/006466
(87) International publication number: WO 2005/099315

(57) **Abstract**

An EL element includes a light-emitting layer (1), a color filter layer (4a-4c, 5a-5c), and a surface substrate (9). The color filter layer (4a-4c, 5a-5c) and the surface substrate (9) are located on the light extraction side. The color filter layer (4a-4c, 5a-5c) is present between transparent electrodes (3) formed on the light emitting layer and the surface substrate (9), and includes light-emitting portions of three primary colors and light shielding layers (6) formed between each of the light-emitting portions. The sides of the light shielding layers (6) or the light-emitting portions are covered with a metal reflective layer (7). This allows diffused light to be reflected back to each of the light-emitting portions, so that light can be extracted efficiently on the screen side. The metal reflective layer is connected electrically to the transparent electrodes and can reduce the electrical resistance value of the transparent electrodes. The EL element can improve the light extraction efficiency of the color filter layer.

## Description

### Technical Field

The present invention relates to an electroluminescent (EL) element used, e.g., in a display device.

### Background Art

In recent years, a flat display has attracted considerable attention as a display device. For example, a plasma display is in practical use. The plasma display has the advantages of increasing the screen size easily and achieving high brightness and a wide viewing angle. However, the display structure is complicated, and the manufacturing process also is complicated. Therefore, despite the steady progress of the plasma display, it is still expensive at the present time.

A display employing the electroluminescent (EL) phenomena also has been proposed. In inorganic electroluminescence, an inorganic phosphor of a semiconductor is placed between electrodes, and light is emitted when recombination or exciton formation of an electron and a hole occurs in the inorganic phosphor by applied voltage. Alternatively, light is emitted when an atom or ion that acts as a light emission center is excited by collisions of accelerating electrons in the semiconductor, and then the excited atom or ion is returned to its original state. As an inorganic EL display, e.g., a phosphor (light-emitting) layer is formed by vapor deposition such as sputtering, and a dielectric layer is arranged on both sides of the phosphor layer for electrical insulation. The EL element emits light by applying an electric field between the electrodes sandwiching the phosphor layer. This principle is used to display characters or images (referred to as "images or the like" in the following). Afull-color display, besides a single-color display, can be provided by converting a single color of light with a color conversion layer.

There has been proposed a conventional technique in which a black matrix (shield) is formed between the light-emitting portions of three primary colors of a color filter (see, e.g., Patent Document 1).

In the Patent Document 1, however, the black matrix is formed on the same surface as thin color filter layers, and light is diffused laterally in color conversion layers or transparent resin layers formed on the color filter layers. Thus, the light extraction efficiency is low. Moreover, the diffused light is absorbed by shielding layers.
Patent Document 1: JP 2002-318543 A

### Disclosure of Invention

Therefore, with respect to the foregoing, it is an object of the present invention to provide an EL element that can improve the light extraction efficiency of a color filter layer and suppress unnecessary power consumption in transparent electrodes.

An EL element of the present invention includes a light-emitting layer, a color filter layer, and a surface substrate. The color filter layer and the surface substrate are located on the light extraction side. The color filter layer is present between transparent electrodes formed on the light-emitting layer and the surface substrate. The color filter layer includes light-emitting portions of three primary colors and light shielding layers formed between each of the light-emitting portions. The sides of the light shielding layers are covered with a metal reflective layer. The metal reflective layer is connected electrically to the transparent electrodes.

### Brief Description of Drawings

FIG. 1 is a cross-sectional view showing a light extraction portion for extracting light from the light-emitting portions of an EL element according to an embodiment of the present invention.
FIG. 2 is a cross-sectional view showing an EL element according to an embodiment of the present invention. Description of Reference Numerals

1: phosphor (light-emitting) layer, 2: anti-diffusion layer, 3: transparent electrode, 4a: red conversion layer, 4b: green conversion layer, 4c: transparent resin layer, 5a: red color filter layer, 5b: green color filter layer, 5c: blue color filter layer, 6: light shielding layer, 7: aluminum metal reflective layer, 8: black matrix, 9: surface glass, 10: light extraction portion, 20: EL element

### Best Mode for Carrying Out the Invention

The present invention provides an EL element that can improve the light extraction efficiency of the color filter layer by covering the sides of the light shielding layers with the metal reflective layer to reflect light from the light-emitting portions of three primary colors of the color filter layer. The light shielding layers are inherently likely to absorb light, and therefore diffused light is absorbed and does not come out easily on the screen side. However, when the light shielding layers are provided with reflecting surfaces of metal, the diffused light is reflected back to each of the light-emitting portions, so that light can be extracted efficiently on the screen side. In other words, light that passes through the transparent electrodes and enters the color filter layer can be extracted directly or by reflection from the metal reflective layer on the screen side.

Moreover, the metal reflective layer is connected electrically to the transparent electrodes. Accordingly, the electrical resistance value of the transparent electrodes can be reduced, thus suppressing unnecessary power consumption due to Joule heating in the transparent electrodes.

The color filter layer of the present invention includes the light-emitting portions of three primary colors and the light shielding layers formed between each of the light-emitting portions. The sides of the light shielding layers are covered with the metal reflective layer to reflect light from the light-emitting portions.

The metal reflective layer is connected electrically to the transparent electrodes and can reduce the electrical resistance of the transparent electrodes. Thus, it is possible not only to suppress unnecessary power consumption in the transparent electrodes, but also to increase applying electric power to the light emitting portion.

It is preferable that a black layer is formed on the surfaces of the metal reflective layer and the light shielding layers, i.e., the surfaces facing the surface substrate. This can prevent reflection from the screen and produce good quality images.

It is preferable that the metal reflective layer is formed of aluminum having a thickness of 0.05 µm to 1 µm. The aluminum metal reflective layer can be formed, e.g., by vapor deposition or sputtering. The metal reflective layer may cause reflection like a half mirror as well as total reflection.

The metal reflective layer also may be formed of a silver electrode having a thickness of 1 µm to 10 µm.

In the present invention, an anti-diffusion layer for preventing the diffusion of a fluorescent material may be arranged between the light-emitting layer and the transparent electrodes. As the anti-diffusion layer, e.g., Al₂O₃ is formed in a thickness of 0.1 µm to 1 µm.

### Embodiment 1

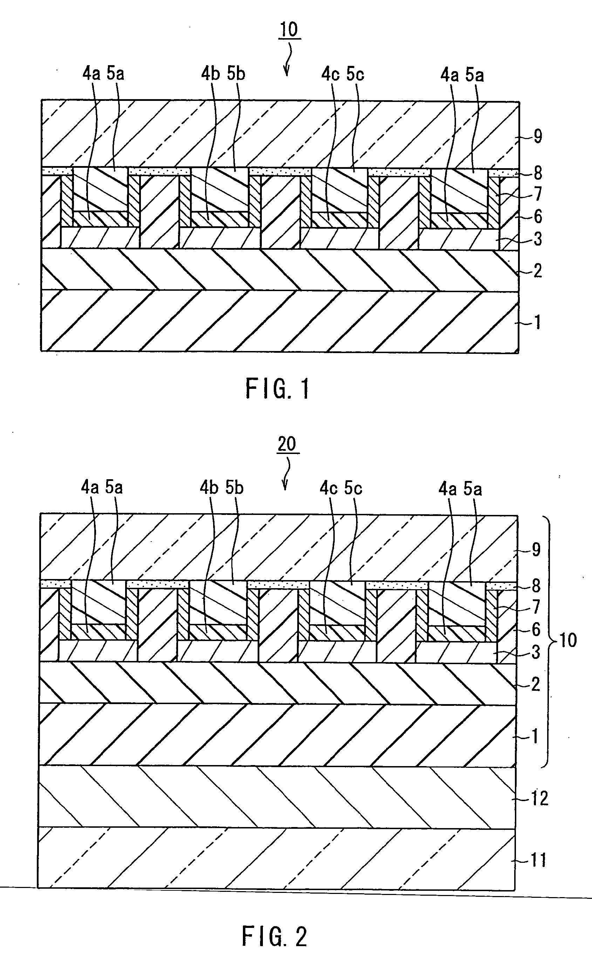

Hereinafter, the present invention will be described with reference to the drawings. FIG. 1 is a cross-sectional view showing a light extraction portion 10 for extracting light from the light-emitting portions of an EL element in this embodiment. A phosphor (light-emitting) layer 1 is made of BaAl₂S₄:Eu and has a thickness of 0.4 µm. An anti-diffusion layer 2 is formed on the entire surface of the phosphor layer 1 by sputtering. The anti-diffusion layer 2 is made of Al₂O₃ and has a thickness of 0.5 µm. Transparent electrodes 3, each of which is made of an indium tin oxide (ITO) alloy layer having a thickness of 0.5 µm and a width of 150 µm, are formed in parallel on the anti-diffusion layer 2 by sputtering.

Using an electrical insulating paste obtained by kneading a polymethyl methacrylate resin (PMMA with a refractive index of 1.49, manufactured by Sumitomo Chemical Co., Ltd.) and a small amount of graphite, a light shielding layer 6 having a thickness of 16 µm is formed between the transparent electrodes 3 by printing. The light shielding layer 6 slopes at 75 degrees due to the surface tension of the paste.

Subsequently, the central portions of the surfaces of each of the transparent electrodes 3 and the light shielding layers 6 are masked with photosensitive polyvinyl pyrrolidone (PVP). Then, an aluminum metal reflective layer 7 is formed on the edges of the transparent electrodes 3 and along the sloping sides of the light shielding layers 6 by vapor deposition in a vacuum at 10⁻³ Pa so that electric connection is made between the aluminum metal reflective layer 7 and the transparent electrodes 3. Thereafter, the PVP layer is swollen and peeled off using a hydrogen peroxide solution, and excess aluminum is removed by the lift-off technology. In this case, the aluminum metal reflective layer 7 has a thickness of 0.1 µm. When the thickness is less than 0.05 µm, the reflection intensity is not sufficient. When the thickness is more than 1 µm, the aluminum metal reflective layer 7 tends to peel off. Therefore, a preferred thickness of the aluminum metal reflective layer 7 is 0.05 µm to 1 µm.

Next, a 12 µm thick red conversion layer 4a and a 3 µm thick red color filter layer 5a are formed as a red filter layer on the transparent electrode 3 and between the aluminum metal reflective layers 7 by screen printing. Similarly, a 13 µm thick green conversion layer 4b and a 4 µm thick green color filter layer 5b are formed as a green filter layer. Moreover, a 12 µm thick transparent resin layer 4c (since the light-emitting layer 1 emits blue light, color conversion is not required) and a 3 µm thick blue color filter layer 5c are formed as a blue filter layer. The red filter layer, the green filter layer, and the blue filter layer are printed in this order. A screen printing mesh with 400 mesh/inch is used. After printing, the solvent is evaporated gradually, and drying is performed at 170°C for 60 minutes.

The following pigments are used in this embodiment.
(1) Green: copper halide phthalocyanine pigment (C. I. Pigment Green 36)
(2) Red: anthraquinone pigment (C. I. Pigment Red 177)
To enhance the color purity, a blue color filter layer using a copper phthalocyanine pigment (C. I. Pigment Blue 15:6) may be formed instead of the transparent resin layer 4c.

Next, a black matrix 8 that is made of a graphite material and has a thickness of 2 µm and a width of 50 µm is formed on the light shielding layers 6 and the aluminum metal reflective layers 7.

The black matrix 8 may be formed in the following manner: a paste is produced by mixing 5 wt% of graphite powder with an average particle size of 0.3 µm, 15 wt% of PMMA resin, and 80 wt% of benzyl alcohol and stirring the mixture at 90°C for 20 minutes so that the viscosity is 15 Pa·Sec; the paste is applied to the surface of a glass substrate by screen printing, dried, and then is baked at 120°C. The black matrix 8 also can be formed on a surface glass 9.

Finally, the surface glass 9 is provided.

FIG. 2 is a cross-sectional view showing an EL element 20 that incorporates the light extraction portion 10 in FIG. 1. The EL element 20 includes a back glass 11, a back electrode 12 formed on the back glass 11, a dielectric layer 1 that is made from BaTiO₃ and has a thickness of 30 µm, and a smoothing layer 14 that is made of BaTiO₃ organic acid and has a thickness of 0.6 µm. The light extraction portion 10 is formed on the smoothing layer 14. When an alternating voltage of 1 kHz, 180 V was applied to the EL element 20, the brightness increased by about 20% compared to an EL element that did not include the aluminum metal reflective layer 7.

In the above embodiment of the present invention, a 30 µm thick BaTiO₃ layer is used as the dielectric layer on the back electrode. However, the dielectric layer does not have to be that thick and may be, e.g., a 7 µm thick SrTiO₃ layer formed by sputtering.

In the above embodiment of the present invention, the sides of the light shielding layer 6 are covered with the aluminum metal reflective layer 7 having a thickness of 0.1 µm. However, any metal with a low electrical resistance value and a high reflectance can be used as an electrode. For example, it is also possible to use a silver electrode that is formed of a photo-curing silver paste and has a thickness of 1 µm to 10 µm.

## Claims

1. An electroluminescent element comprising:
a light-emitting layer;
a color filter layer; and
a surface substrate,
wherein the color filter layer and the surface substrate are located on a light extraction side,
the color filter layer is present between transparent electrodes formed on the light-emitting layer and the surface substrate, and comprises light-emitting portions of three primary colors and light shielding layers formed between each of the light-emitting portions,
sides of the light shielding layers are covered with a metal reflective layer, and
the metal reflective layer is connected electrically to the transparent electrodes.

2. The electroluminescent element according to claim 1, wherein a black layer is formed on surfaces of the metal reflective layer and the light shielding layers that face the surface substrate.

3. The electroluminescent element according to claim 1, wherein the metal reflective layer is formed of aluminum having a thickness of 0.05 µm to 1 µm.

4. The electroluminescent element according to claim 1, wherein the metal reflective layer is formed of a silver electrode having a thickness of 1 µm to 10 µm.

5. The electroluminescent element according to claim 1, wherein the color filter layer further comprises a red conversion layer, a green conversion layer, and a transparent resin layer.

## Amended claims

### Amended claims under Art. 19.1 PCT

1. (Amended) An electroluminescent element comprising:
a light-emitting layer;
a color filter layer; and
a surface substrate,
wherein the color filter layer and the surface substrate are located on a light extraction side,
the color filter layer is present between transparent electrodes formed on the light-emitting layer and the surface substrate,
the transparent electrodes are in the form of stripes and separated for each color of red (R), green (G) and blue (B),
the color filter layer comprises light-emitting portions of three primary colors and light shielding layers formed between each of the light-emitting portions,
sides of the light shielding layers are covered with a metal reflective layer in a longitudinal direction of the transparent electrodes, and
the metal reflective layer is connected electrically to the transparent electrodes in the longitudinal direction.

2. The electroluminescent element according to claim 1, wherein a black layer is formed on surfaces of the metal reflective layer and the light shielding layers that face the surface substrate.

3. The electroluminescent element according to claim 1, wherein the metal reflective layer is formed of aluminum having a thickness of 0.05 µm to 1 µm.

4. The electroluminescent element according to claim 1, wherein the metal reflective layer is formed of a silver electrode having a thickness of 1 µm to 10 µm.

5. The electroluminescent element according to claim 1, wherein the color filter layer further comprises a red conversion layer, a green conversion layer, and a transparent resin layer.
